# FASCICULE DE BREVET EUROPEEN

(11) **EP 4 295 166 B1**
(45) Date de publication et mention de la délivrance du brevet: **25.02.2026**
(21) Numéro de dépôt: 22703016.0
(22) Date de dépôt: 04.01.2022
(51) Int. Cl.: G01R 31/36, G01R 31/389, G01R 31/392

(54) **SURVEILLANCE DE L'ÉTAT D'UNE BATTERIE DE SERVITUDE D'UN VÉHICULE À GMP ÉLECTRIQUE, PAR TESTS SÉCURITAIRES**
ÜBERWACHUNG DES ZUSTANDES EINER NIEDERSPANNUNGS-AKKUMULATOR EINES FAHRZEUGS MIT EINEM ELEKTRISCHEN ANTRIEB DURCH SICHERHEITSTESTS
MONITORING, BY MEANS OF SAFETY TESTS, THE STATUS OF A LOW-VOLTAGE RECHARGEABLE BATTERY OF A VEHICLE HAVING AN ELECTRIC POWER TRAIN

(30) Priorité: 18.02.2021 FR 2101559
(43) Date de publication de la demande: 27.12.2023
(73) Titulaire: Stellantis Auto SAS, 78300 Poissy (FR)
(72) Inventeur: BOTCHON, Yannick, 92160 Antony (FR); PERSEVAL, Herve, 91310 Montlhéry (FR)
(74) Mandataire: PSIP
(86) Numéro de dépôt international: PCT/FR2022/050015
(87) Numéro de publication internationale: WO 2022/175606

(56) Documents cités:
- EP-A1- 1 207 083
- DE-A1- 10 125 819
- FR-A1- 2 986 381
- FR-A1- 2 987 939
- FR-A1- 3 013 903

## Description

La présente invention revendique la priorité de la demande française N°2101559 déposée le 18.02.2021.

### Domaine technique de l'invention

L'invention concerne les véhicules à groupe motopropulseur (ou GMP) électrique, et plus précisément la surveillance de l'état de la batterie de servitude de tels véhicules.

### Etat de la technique

Comme le sait l'homme de l'art, certains véhicules comprennent un groupe motopropulseur (ou GMP) et un réseau de bord alimenté en énergie électrique par un groupe d'alimentation comprenant une batterie de servitude rechargeable et au moins un générateur d'énergie électrique couplés entre eux (directement ou indirectement). Par exemple, ce générateur d'énergie électrique peut être un alternateur ou un alterno-démarreur lorsque le GMP comprend au moins une machine motrice thermique, ou bien un convertisseur, de type courant continu/courant continu (ou DC/DC) et associé à une batterie principale de type basse, moyenne ou haute tension, lorsque le GMP comprend au moins une machine motrice électrique.

Dans ce qui suit et ce qui précède, on entend par « batterie de servitude » une batterie rechargeable par au moins un générateur d'énergie électrique et de type très basse tension (typiquement 12 V, 24 V ou 48 V).

Par ailleurs, dans ce qui suit et ce qui précède, on entend par « réseau de bord » un réseau d'alimentation électrique comprenant des équipements (ou organes) électriques (ou électroniques) consommant de l'énergie électrique et étant « non prioritaire(s) » pour l'un au moins d'entre eux et « sécuritaire(s) » (et donc prioritaire(s)) pour au moins un autre d'entre eux. De plus, dans ce qui suit et ce qui précède, on entend par « équipement (ou organe) sécuritaire » un équipement (ou organe) assurant au moins une fonction dite « sécuritaire » du fait qu'elle concerne la sécurité des passagers d'un véhicule, et donc devant être alimenté en énergie électrique de façon prioritaire. C'est le cas, par exemple, de la direction assistée électrique ou d'un dispositif de freinage électrique (frein de service, frein de secours, système d'aide au freinage ou anti-patinage, par exemple).

Dans certaines situations de vie d'un véhicule, comme par exemple lors de manœuvres dites d'urgence (telles que des freinages d'urgence ou des évitements), il est indispensable que les organes sécuritaires participant à ces manœuvres soient alimentés avec un niveau de puissance électrique qui garantit leur fonctionnement, ainsi que leur niveau de performance attendu. C'est le groupe d'alimentation du véhicule qui est responsable de la fourniture de ce niveau de puissance électrique aux organes sécuritaires concernés à l'instant considéré. On notera que ce groupe d'alimentation est aussi responsable de la fourniture, en parallèle, du niveau de puissance électrique qui est nécessaire au fonctionnement des autres organes non sécuritaires utilisés à l'instant considéré.

En cas d'incapacité du groupe d'alimentation à fournir la puissance électrique nécessaire à tous les organes électriques concernés à l'instant considéré, un écroulement de la tension pourrait survenir aux bornes du réseau de bord et donc des organes électriques sécuritaires, ce qui ne permettrait pas à ces derniers de fonctionner correctement (c'est-à-dire avec un niveau de performance suffisant), et donc pourrait mettre en danger les passagers du véhicule et/ou ce dernier et/ou des personnes situées dans l'environnement de ce véhicule.

Lorsque le véhicule comprend à la fois une batterie de servitude et une batterie principale (fournissant de l'énergie électrique pour au moins une machine motrice électrique du GMP), c'est la batterie principale qui est principalement sollicitée pour alimenter le réseau de bord. La batterie de servitude fournit de l'énergie électrique pour démarrer l'éventuelle machine motrice thermique, et assure un complément d'alimentation électrique permettant d'éviter l'écroulement du réseau de bord en cas de forte consommation énergétique transitoire. Par conséquent, dans un véhicule à GMP au moins partiellement thermique lorsque la batterie de servitude est dans un état dégradé ou faiblement chargée, la machine motrice thermique ne peut pas être démarrée ce qui alerte le conducteur. Mais, dans un véhicule à GMP purement électrique, la batterie de servitude peut avoir le niveau de puissance requis (pas très élevé) pour alimenter des calculateurs (nécessaires à la mise en action du véhicule), mais ce niveau de puissance peut être insuffisant pour assurer les besoins d'alimentation électrique sécuritaire, ce qui fait courir un risque aux passagers du véhicule.

Dans le document brevet EP-A1 1207083, il a été proposé de déterminer si la capacité de la batterie de servitude est inférieure à un seuil choisi de manière à satisfaire au minimum les besoins d'alimentation électrique d'une direction assistée électrique ou d'un système électrique de freinage, et dans l'affirmative de déclencher une limitation de la vitesse maximale du véhicule. Mais cela ne permet pas de déterminer l'état réel dans lequel se trouve la batterie de servitude. En outre, cela ne permet pas d'informer le conducteur d'un éventuel risque. De plus, si la mesure de capacité n'est pas fiable, la limitation de vitesse peut être injustifiée ou être une mesure insuffisante en présence d'un risque sécuritaire.

Le document FR 3 013 903 A1 décrit un dispositif de diagnostic permettant de déterminer l'état de santé d'une batterie dans un véhicule. Une unité d'analyse calcule la résistance interne de la batterie et une unité de commande génère une alarme lorsque la résistance interne est supérieure à un seuil défini.

L'invention a donc notamment pour but de déterminer l'état réel de la batterie de servitude d'un véhicule à GMP purement électrique, par des tests sécuritaires.

### Présentation de l'invention

Elle propose notamment à cet effet un dispositif de surveillance destiné à équiper un véhicule comprenant un groupe motopropulseur électrique et un réseau de bord alimenté en énergie électrique par un groupe d'alimentation comportant une batterie de servitude rechargeable et au moins un générateur d'énergie électrique.

Ce dispositif de surveillance se caractérise par le fait qu'il comprend au moins un processeur et au moins une mémoire agencés pour effectuer les opérations consistant, en cas de mise en fonctionnement du groupe motopropulseur électrique, à déclencher une consommation de courant choisie par le réseau de bord via le générateur d'énergie électrique puis via la batterie de servitude, au moins une fois, afin de déterminer une tension minimale aux bornes de la batterie de servitude et une résistance interne de cette dernière, puis à déterminer un état de la batterie de servitude en fonction de ces tension minimale et résistance interne déterminées.

Ainsi, on dispose de l'état réel de la batterie de servitude juste avant que le véhicule ne commence à circuler, ce qui est particulièrement rassurant pour ses passagers.

Le dispositif de surveillance selon l'invention peut comporter d'autres caractéristiques qui peuvent être prises séparément ou en combinaison, et notamment :
- son processeur et sa mémoire peuvent être agencés pour effectuer les opérations consistant à déclencher une consommation de courant choisie par le réseau de bord via le générateur d'énergie électrique puis via la batterie de servitude, au moins deux fois de suite pendant une première durée choisie, afin de déterminer à chaque fois une tension minimale aux bornes de la batterie de servitude et une résistance interne de cette dernière, puis à déterminer une tension minimale moyenne à partir de ces tensions minimales déterminées et une résistance interne moyenne à partir de ces résistances internes déterminées, puis l'état de la batterie de servitude en fonction de ces tension minimale moyenne et résistance interne moyenne déterminées ;
- en présence de la dernière option, son processeur et sa mémoire peuvent être agencés pour effectuer les opérations consistant à déclencher une consommation de courant par le réseau de bord via le générateur d'énergie électrique pendant une deuxième durée choisie, après chaque consommation de courant choisie par le réseau de bord via la batterie de servitude pendant la première durée choisie, hormis une dernière consommation de courant choisie par le réseau de bord via la batterie de servitude ;
- son processeur et sa mémoire peuvent être agencés pour effectuer les opérations consistant à déclencher la consommation de courant choisie par le réseau de bord via le générateur d'énergie électrique pendant une troisième durée choisie faisant suite à une autre consommation de courant, non déclenchée, par le réseau de bord via le générateur d'énergie électrique pendant une quatrième durée choisie ;
- son processeur et sa mémoire peuvent être agencés pour effectuer les opérations consistant à déclencher chaque consommation de courant choisie par le réseau de bord via la batterie de servitude en déclenchant une réduction de tension choisie du générateur d'énergie électrique pendant un intervalle de temps compris entre 1 ms et 8 ms ;
- son processeur et sa mémoire peuvent être agencés pour effectuer les opérations consistant à déterminer chaque tension minimale et chaque résistance interne lorsqu'un courant sortant de la batterie de servitude croit d'une valeur supérieure à un premier seuil pendant une durée paramétrable débutant en même temps que débute une première durée choisie ;
- son processeur et sa mémoire peuvent être agencés pour effectuer les opérations consistant à déterminer l'état dans un groupe comprenant un premier état représentatif d'une impossibilité à assurer une alimentation électrique du réseau de bord adaptée à des besoins d'alimentation électrique au moins partielle d'au moins un organe électrique sécuritaire, d'un deuxième état représentatif d'une incertitude de capacité à assurer une alimentation électrique du réseau de bord adaptée à des besoins d'alimentation électrique au moins partielle d'au moins un organe électrique sécuritaire, et d'un troisième état représentatif d'une capacité à assurer une alimentation électrique du réseau de bord adaptée à des besoins d'alimentation électrique au moins partielle d'au moins un organe électrique sécuritaire ;
- en présence de la dernière option, son processeur et sa mémoire peuvent être agencés pour effectuer les opérations consistant, en cas de détermination du premier état, à déclencher au moins une alerte d'un passager du véhicule choisie parmi une alerte de risque encouru et une alerte de préconisation d'au moins une action à effectuer, et en cas de détermination du deuxième état, à déclencher une alerte de service pour ce passager ;
- son processeur et sa mémoire peuvent être agencés pour effectuer les opérations consistant à déterminer l'état en fonction en outre d'une information de fiabilité ;
- en présence de la dernière option, son processeur et sa mémoire peuvent être agencés pour effectuer les opérations consistant à déterminer l'état lorsque l'information de fiabilité du test est représentative d'une fiabilité certaine.

L'invention propose également un véhicule, éventuellement de type automobile, et comprenant un groupe motopropulseur électrique, un réseau de bord alimenté en énergie électrique par un groupe d'alimentation comportant une batterie de servitude rechargeable et au moins un générateur d'énergie électrique, ainsi qu'un dispositif de surveillance du type de celui présenté ci-avant.

L'invention propose également un procédé de surveillance destiné à être mis en œuvre dans un véhicule comprenant un groupe motopropulseur électrique et un réseau de bord alimenté en énergie électrique par un groupe d'alimentation comportant une batterie de servitude rechargeable et au moins un générateur d'énergie électrique.

Ce procédé de surveillance se caractérise par le fait qu'il comprend une étape dans laquelle, en cas de mise en fonctionnement du groupe motopropulseur électrique, on déclenche une consommation de courant choisie par le réseau de bord via le générateur d'énergie électrique puis via la batterie de servitude, au moins une fois, afin de déterminer une tension minimale aux bornes de la batterie de servitude et une résistance interne de cette dernière, puis on détermine un état de la batterie de servitude en fonction de ces tension minimale et résistance interne déterminées.

L'invention propose également un produit programme d'ordinateur comprenant un jeu d'instructions qui, lorsqu'il est exécuté par des moyens de traitement, est propre à mettre en œuvre le procédé de surveillance présenté ci-avant pour surveiller l'état d'une batterie de servitude rechargeable d'un véhicule comprenant un groupe motopropulseur électrique et un réseau de bord alimenté en énergie électrique par un groupe d'alimentation comportant cette batterie de servitude et au moins un générateur d'énergie électrique.

### Brève description des figures

D'autres caractéristiques et avantages de l'invention apparaîtront à l'examen de la description détaillée ci-après, et des dessins annexés, sur lesquels :
[Fig. 1] illustre schématiquement et fonctionnellement un exemple de réalisation d'un véhicule comprenant un GMP purement électrique et un boîtier de distribution comportant un dispositif de surveillance selon l'invention,
[Fig. 2] illustre schématiquement et fonctionnellement un exemple de réalisation d'un calculateur de supervision de la distribution d'énergie électrique comprenant un exemple de réalisation d'un dispositif de surveillance selon l'invention, et
[Fig. 3] illustre schématiquement un exemple d'algorithme mettant en œuvre un procédé de surveillance selon l'invention.

### Description détaillée de l'invention

L'invention a notamment pour but de proposer un dispositif de surveillance DS, et un procédé de surveillance associé, destinés à permettre la surveillance, par des tests sécuritaires, de l'état d'une batterie de servitude BS rechargeable d'un véhicule V à groupe motopropulseur (ou GMP) purement électrique.

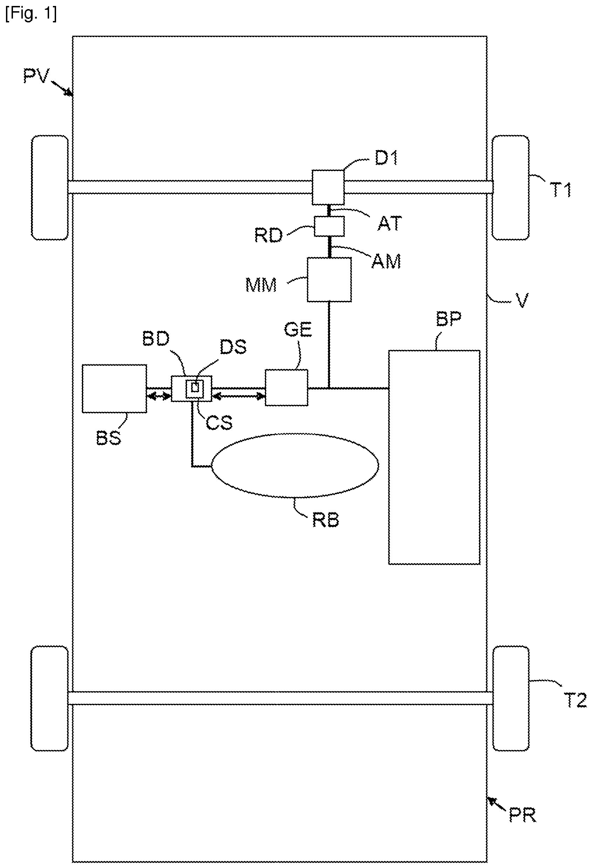

Dans ce qui suit, on considère, à titre d'exemple non limitatif, que le véhicule V est de type automobile. Il s'agit par exemple d'une voiture, comme illustré sur la figure 1. Mais l'invention n'est pas limitée à ce type de véhicule. Elle concerne en effet tout type de véhicule comprenant un GMP électrique et un réseau de bord alimenté en énergie électrique par un groupe d'alimentation comportant une batterie de servitude rechargeable et au moins un générateur d'énergie électrique. Ainsi, elle concerne, par exemple, les véhicules terrestres (véhicules utilitaires, camping-cars, minibus, cars, camions, motocyclettes, engins de voirie, engins de chantier, engins agricoles, engins de loisir (motoneige, kart), et engins à chenille(s), par exemple), les bateaux et les aéronefs.

On a schématiquement représenté sur la figure 1 un véhicule V comprenant une chaîne de transmission à GMP électrique, un réseau de bord RB, une batterie de servitude BS, un générateur d'énergie électrique GE et un dispositif de surveillance DS selon l'invention.

Le réseau de bord RB est un réseau d'alimentation électrique qui comprend des équipements (ou organes) électriques (ou électroniques) qui consomment de l'énergie électrique. Au moins l'un de ces équipements (ou organes) électriques (ou électroniques) est « non prioritaire » et au moins un autre de ces équipements (ou organes) électriques (ou électroniques) est « sécuritaire » (et donc prioritaire).

Il est rappelé que l'on entend ici par « équipement (ou organe) sécuritaire » un équipement (ou organe) consommant de l'énergie électrique pour assurer au moins une fonction dite sécuritaire (car concernant la sécurité des passagers du véhicule V), et donc devant être alimenté en énergie électrique de façon prioritaire. Il pourra s'agir, par exemple, de la direction assistée électrique ou d'un dispositif de freinage électrique (frein de service, frein de secours, système d'aide au freinage ou anti-patinage, par exemple).

Un équipement (ou organe) électrique (ou électronique) non prioritaire consomme de l'énergie électrique pour assurer au moins une fonction qui n'est pas indispensable, comme par exemple le chauffage/climatisation ou le chauffage de siège ou le dispositif de massage de siège.

La batterie de servitude BS est chargée de fournir de l'énergie électrique au réseau de bord RB, en complément de celle fournie par la batterie principale BP décrite plus loin. Par exemple, cette batterie de servitude BS peut être agencée sous la forme d'une batterie de type très basse tension (typiquement 12 V, 24 V ou 48 V). Elle est rechargeable par un générateur d'énergie électrique GE du véhicule V.

La chaîne de transmission a un GMP purement électrique et donc comprend, notamment, une machine motrice MM électrique, un arbre moteur AM, une batterie principale BP et un arbre de transmission AT.

On entend ici par « machine motrice électrique » une machine électrique agencée de manière à fournir ou récupérer du couple pour déplacer le véhicule V.

La machine motrice MM (ici un moteur électrique) est couplée à la batterie principale BP, afin d'être alimentée en énergie électrique, ainsi qu'éventuellement d'alimenter cette batterie principale BP en énergie électrique. Elle est couplée à l'arbre moteur AM, pour lui fournir du couple par entraînement en rotation. Cet arbre moteur AM est ici couplé à un réducteur RD qui est aussi couplé à l'arbre de transmission AT, lui-même couplé à un premier train T1 (ici de roues), de préférence via un différentiel D1.

Ce premier train T1 est ici situé dans la partie avant PV du véhicule V. Mais dans une variante ce premier train T1 pourrait être celui qui est ici référencé T2 et qui est situé dans la partie arrière PR du véhicule V.

Par exemple, la batterie principale BP peut être de type basse tension (typiquement 400 V à titre illustratif). Mais elle pourrait être de type moyenne tension ou haute tension.

La machine motrice MM est aussi couplée au générateur d'énergie électrique GE qui est aussi couplé (ici indirectement) à la batterie de servitude BS, notamment pour la recharger avec de l'énergie électrique issue de la batterie principale BP et convertie.

Ce générateur d'énergie électrique GE est un convertisseur de type courant continu/courant continu (ou DC/DC), à titre d'exemple. Outre la recharge de la batterie de servitude BS, il est aussi chargé d'alimenter le réseau de bord RB en énergie électrique issue de la batterie principale BP et convertie.

On notera également que dans l'exemple illustré non limitativement sur la figure 1 le véhicule V comprend un boîtier de distribution BD auquel sont couplés la batterie de servitude BS, le générateur d'énergie électrique GE et le réseau de bord RB. Ce boîtier de distribution BD est chargé de distribuer dans le réseau de bord RB l'énergie électrique stockée dans la batterie de servitude BS ou produite par le générateur d'énergie électrique GE, pour l'alimentation des organes (ou équipements) électriques en fonction de demandes d'alimentation reçues. La supervision de la distribution de cette énergie électrique peut être assurée par un calculateur CS. Dans l'exemple illustré non limitativement sur la figure 1, le calculateur de supervision CS fait partie du boîtier de distribution BD. Mais dans une variante de réalisation (non illustrée) le calculateur de supervision CS pourrait ne pas faire partie du boîtier de distribution BD.

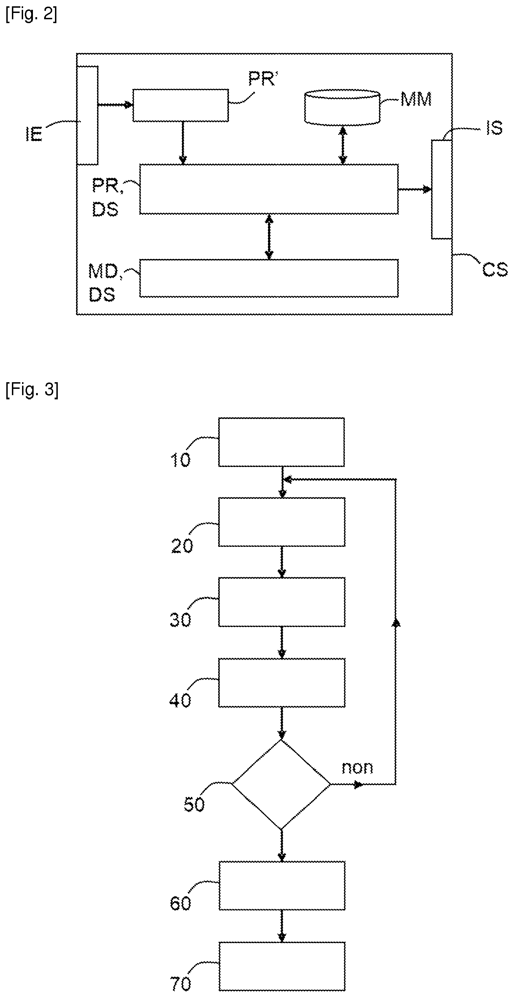

Comme illustré non limitativement sur la figure 2, un dispositif de surveillance DS, selon l'invention, comprend au moins un processeur PR et au moins une mémoire MD qui sont agencés pour effectuer des opérations au moins lors de chaque mise en fonctionnement du groupe motopropulseur électrique.

Ces opérations consistent tout d'abord, en cas de mise en fonctionnement du groupe motopropulseur électrique, à déclencher une consommation de courant choisie ccc par le réseau de bord RB, tout d'abord via le générateur d'énergie électrique GE, puis via la batterie de servitude BS, au moins une fois, afin de déterminer une tension minimale um aux bornes de la batterie de servitude BS et une résistance interne rm de cette dernière (BS). Ces opérations consistent ensuite à déterminer un état de la batterie de servitude BS en fonction de cette tension minimale um déterminée et de cette résistance interne rm déterminée.

On comprendra que chaque déclenchement d'une consommation de courant choisie ccc par le réseau de bord RB, via le générateur d'énergie électrique GE puis via la batterie de servitude BS, au moins une fois, constitue un test sécuritaire de la batterie de servitude BS.

On dispose ainsi de l'état réel en cours de la batterie de servitude BS, juste avant que le véhicule V ne commence à circuler. Cela est particulièrement rassurant notamment lorsque la batterie de servitude BS est dans un état dégradé ou faiblement chargé qui empêchera d'assurer les besoins d'alimentation électrique sécuritaire au sein du véhicule V.

On notera que dans l'exemple illustré non limitativement sur les figures 1 et 2, le processeur PR et la mémoire MD font partie du calculateur de supervision CS qui est réalisé sous la forme d'une combinaison de circuits ou composants électriques ou électroniques (ou « hardware ») et de modules logiciels (ou « software »). Mais dans une variante de réalisation (non illustrée) le processeur PR et la mémoire MD pourraient faire partie d'un calculateur qui n'est pas le calculateur de supervision CS et donc assurant au moins une autre fonction au sein du véhicule V. Un tel calculateur pourrait être externe au boîtier de distribution BD. Dans une autre variante de réalisation (non illustrée) le dispositif de surveillance DS pourrait comprendre son propre calculateur comportant notamment son processeur PR et sa mémoire MD. Dans ce cas il peut faire partie du boîtier de distribution BD ou être externe à ce dernier (BD). Le processeur PR peut, par exemple, être un processeur de signal numérique (ou DSP (« Digital Signal Processor »)). Ce processeur PR peut comprendre des circuits intégrés (ou imprimés), ou bien plusieurs circuits intégrés (ou imprimés) reliés par des connections filaires ou non filaires. On entend par circuit intégré (ou imprimé) tout type de dispositif apte à effectuer au moins une opération électrique ou électronique. Ainsi, il peut, par exemple, s'agir d'un microcontrôleur.

La mémoire MD est vive afin de stocker des instructions pour la mise en œuvre par le processeur PR d'une partie au moins du procédé de surveillance décrit plus loin (et donc de ses fonctionnalités).

On notera que le processeur PR et la mémoire MD peuvent être aussi agencés pour effectuer les opérations consistant à déclencher une consommation de courant choisie ccc par le réseau de bord RB via le générateur d'énergie électrique GE puis via la batterie de servitude BS, au moins deux fois de suite pendant une première durée d1 choisie, afin de déterminer à chaque fois la tension minimale umk aux bornes de la batterie de servitude BS et la résistance interne rmk de cette dernière (BS). Dans ce cas, le processeur PR et la mémoire MD sont aussi agencés pour effectuer les opérations consistant à déterminer la tension minimale moyenne um à partir de ces tensions minimales umk déterminées et la résistance interne moyenne rm à partir de ces résistances internes rmk déterminées, puis à déterminer l'état de la batterie de servitude BS en fonction de ces tension minimale moyenne um et résistance interne moyenne rm déterminées.

Les déterminations des tension minimale umk et résistance interne rmk peuvent, par exemple, être effectuées après l'expiration d'une durée paramétrable après l'apparition (ou le début) de la variation (i1 - i2) du courant sortant de la batterie de servitude BS (la dynamique de tension est plus faible que la dynamique de courant). Par exemple, cette durée paramétrable peut être choisie égale à 5 ms. De préférence, chaque détermination d'une résistance interne rmk est effectuée juste après l'expiration de la durée paramétrable, tandis que chaque détermination d'une tension minimale umk est effectuée à l'expiration d'un intervalle de temps débutant juste après l'expiration de la durée paramétrable et ayant une durée strictement inférieure à d1, et par exemple égale à 100 ms. Dans ce cas, on détermine la résistance interne rmk immédiatement après la fin de la variation (i1 - i2) du courant sortant de la batterie de servitude BS (soit 5 ms ou 6 ms après le début de cette variation) et la tension minimale umk 100 ms après la fin de la variation (i1 - i2) du courant sortant de la batterie de servitude BS (soit 105 ms après le début de cette variation).

Chaque tension minimale um peut être déterminée par un premier circuit électronique couplé à la batterie de servitude BS. Par ailleurs, chaque résistance interne rmk peut être déduite de la variation de la tension (u1 - u2) pendant la variation de courant (i1 - i2) et de cette variation du courant (i1 - i2) déterminée par un second circuit électronique (rmk = (u1 - u2)/(i1 - i2)).

Par exemple, le nombre de fois où l'on déclenche une consommation de courant choisie ccc par le réseau de bord RB via le générateur d'énergie électrique GE puis via la batterie de servitude BS pour un test sécuritaire peut être égal à trois. Mais ce nombre peut prendre n'importe quelle valeur supérieure ou égale à un. Ainsi, ce nombre pourrait être égal à un, deux, quatre ou cinq, par exemple.

Egalement par exemple, le processeur PR et la mémoire MD peuvent aussi être agencés pour effectuer les opérations consistant à déclencher une consommation de courant par le réseau de bord RB via le générateur d'énergie électrique GE pendant une deuxième durée d2 choisie, après chaque consommation de courant choisie ccc par le réseau de bord RB via la batterie de servitude BS pendant la première durée d1 choisie, hormis une dernière consommation de courant choisie ccc par le réseau de bord RB via le générateur d'énergie électrique GE. En d'autres termes, dans un test sécuritaire multiple on déclenche une consommation de courant choisie ccc par le réseau de bord RB via le générateur d'énergie électrique GE (éventuellement pendant une deuxième durée d2 choisie), puis on déclenche la consommation de courant choisie ccc par le réseau de bord RB via la batterie de servitude BS pendant une première durée d1 choisie, puis une consommation de courant choisie ccc par le réseau de bord RB via le générateur d'énergie électrique GE pendant une deuxième durée d2 choisie, puis on déclenche de nouveau la consommation de courant choisie ccc par le réseau de bord RB via la batterie de servitude BS pendant une autre première durée d1 choisie, puis une consommation de courant choisie ccc par le réseau de bord RB via le générateur d'énergie électrique GE pendant une autre deuxième durée d2 choisie, et ainsi de suite jusqu'au tout dernier déclenchement de la consommation de courant choisie ccc par le réseau de bord RB via la batterie de servitude BS après laquelle le test sécuritaire prend fin.

Par exemple, chaque première durée d1 peut être comprise entre 100 ms et 300 ms, et chaque deuxième durée d2 peut être comprise entre 100 ms et 300 ms. Ainsi, on peut, par exemple, choisir des première d1 et deuxième d2 durées égales à 200 ms. Mais d1 et d2 peuvent avoir des valeurs différentes. On notera également que le processeur PR et la mémoire MD peuvent être aussi agencés pour effectuer les opérations consistant à déclencher la toute première consommation de courant choisie ccc par le réseau de bord RB via le générateur d'énergie électrique GE pendant une troisième durée d3 choisie qui fait suite à une autre consommation de courant, non déclenchée, ccnd par le réseau de bord RB via le générateur d'énergie électrique GE pendant une quatrième durée d4 choisie, et qui précède la toute première consommation de courant choisie ccc par le réseau de bord RB via la batterie de servitude BS pendant une première durée d1 choisie.

On entend ici par « consommation de courant non déclenchée » une consommation normale de courant par le réseau de bord RB via le générateur d'énergie électrique GE au démarrage du GMP (sans intervention du dispositif de surveillance DS). Par conséquent, lors d'un test sécuritaire chaque consommation de courant choisie ccc est strictement supérieure à la consommation de courant non déclenchée (normale) ccnd. Par exemple, lors d'un test sécuritaire chaque consommation de courant choisie ccc peut être supérieure à 50 A. Ainsi, elle peut, par exemple, être égale à environ 60 A. Par exemple, chaque consommation de courant choisie ccc peut être obtenue par la mise en fonction de résistances de chauffage équipant le véhicule V (et éventuellement de type CTP (« Coefficient de Température Positif »).

Les deux phases, ayant les troisième d3 et quatrième d4 durées et précédant la toute première consommation de courant choisie ccc par le réseau de bord RB via la batterie de servitude BS, peuvent constituer ensemble une phase préparatoire initiale. Chaque phase ayant une première durée d1 choisie peut constituer une phase de diagnostic, et chaque phase ayant une deuxième durée d2 choisie peut constituer une nouvelle phase préparatoire effectuée entre deux phases de diagnostic successives du test sécuritaire.

Cette phase préparatoire initiale (d'une durée (d4+d3) paramétrable) permet de gérer notamment les cas de polarisation de la batterie de servitude BS, par exemple lorsque cette dernière (BS) a été préalablement soumise à une tension élevée (par ex > 14 V) pendant une durée relativement importante (cela peut notamment être le cas d'une tension de charge pendant une phase de roulage du véhicule V précédant un test sécuritaire). Cela permet de minimiser au maximum les imprécisions des déterminations des résistances internes rm (ou rmk) lorsque la batterie de servitude BS n'est pas dans un état stable (ou reposée), ce qui arrive régulièrement entre deux phases de roulage.

Par exemple, la troisième durée d3 peut être égale à la deuxième durée d2. Egalement par exemple, la quatrième durée d4 peut être comprise entre 1 s et 3 s. Ainsi, on peut, par exemple, choisir une quatrième durée d4 égale à 2,8 s. On notera également que le processeur PR et la mémoire MD peuvent être aussi agencés pour effectuer les opérations consistant à déclencher chaque consommation de courant choisie ccc par le réseau de bord RB via la batterie de servitude BS en déclenchant une réduction de tension choisie rt du générateur d'énergie électrique GE pendant un intervalle de temps it compris entre 1 ms et 8 ms. Par exemple, l'intervalle de temps it est la durée paramétrable, et dans ce cas il peut être égal à 5 ms.

On comprendra en effet que lorsque l'on impose une réduction de la valeur de la consigne de tension du générateur d'énergie électrique GE, par exemple en moins de 5 ms, la tension du générateur d'énergie électrique GE devient subitement inférieure (aux chutes de tension près) à la tension réelle de la batterie de servitude BS. Cette dernière (BS) étant reliée au réseau de bord RB, elle va donc devoir fournir à ce dernier (RB) le courant qui était préalablement fourni par le générateur d'énergie électrique GE, ce qui se traduit par une variation du courant sortant de la batterie de servitude BS qui est d'autant plus rapide que la variation de consigne du générateur d'énergie électrique GE est rapide.

Par exemple, dans le cas d'un réseau de bord RB 12 V, on peut réduire la valeur de la consigne de tension du générateur d'énergie électrique GE jusqu'à une valeur d'environ 10,6 V au lieu d'environ 13,1 V dans une phase préparatoire (initiale ou non).

On notera également que le processeur PR et la mémoire MD peuvent être aussi agencés pour effectuer les opérations consistant à déterminer chaque tension minimale et chaque résistance interne lorsque que le courant sortant de la batterie de servitude BS croit d'une valeur qui est supérieure à un premier seuil s1 pendant la durée paramétrable (par exemple égale à 5 ms) qui débute en même temps que débute une première durée d1 choisie.

A la fin du test sécuritaire, et donc après la dernière consommation de courant choisie ccc par le réseau de bord RB via la batterie de servitude BS, la consommation de courant par le réseau de bord RB s'effectue de nouveau via le générateur d'énergie électrique GE de façon non déclenchée et donc normale (ccnd). Cela s'obtient en impose une valeur de consigne de tension normale (ou non réduite) au générateur d'énergie électrique GE.

On notera également que le processeur PR et la mémoire MD peuvent être aussi agencés pour effectuer les opérations consistant à déterminer l'état de la batterie de servitude BS dans un groupe de trois états prédéfinis :
- un premier état e1 peut être représentatif d'une impossibilité de la batterie de servitude BS à assurer une alimentation électrique du réseau de bord RB adaptée à des besoins d'alimentation électrique au moins partielle d'au moins un organe électrique sécuritaire,
- un deuxième état e2 peut être représentatif d'une incertitude de capacité de la batterie de servitude BS à assurer une alimentation électrique du réseau de bord RB adaptée à des besoins d'alimentation électrique au moins partielle d'au moins un organe électrique sécuritaire, et
- un troisième état e3 peut être représentatif d'une capacité de la batterie de servitude BS à assurer une alimentation électrique du réseau de bord RB adaptée à des besoins d'alimentation électrique au moins partielle d'au moins un organe électrique sécuritaire.

On comprendra que lorsque la batterie de servitude BS est dans le premier état e1, elle ne pourra pas fournir le complément d'énergie électrique nécessaire pour satisfaire aux besoins d'alimentation électrique sécuritaire au sein du véhicule V, ce qui est dangereux. En revanche, lorsque la batterie de servitude BS est dans le troisième état e3, elle pourra fournir le complément d'énergie électrique nécessaire pour satisfaire aux besoins d'alimentation électrique sécuritaire au sein du véhicule V. Enfin, lorsque la batterie de servitude BS est dans le deuxième état e2, il existe une probabilité non nulle qu'elle ne puisse pas fournir le complément d'énergie électrique nécessaire pour satisfaire aux besoins d'alimentation électrique sécuritaire au sein du véhicule V, ce qui est potentiellement dangereux.

Pour déterminer l'état de la batterie de servitude BS, le dispositif de surveillance DS peut, par exemple, utiliser une cartographie d'état de la batterie de servitude BS en fonction de sa résistance interne moyenne rm en (milliohms ou ohms) et de sa tension minimale moyenne um (en volts). Les données numériques définissant cette cartographie sont stockées dans la mémoire MD ou dans une mémoire de masse MM sur laquelle on reviendra plus loin.

Mais au lieu d'utiliser une cartographie pour déterminer l'état de la batterie de servitude BS on pourrait utiliser une ou plusieurs formules mathématiques.

En cas de détermination du premier état e1, le processeur PR et la mémoire MD peuvent aussi être agencés pour effectuer les opérations consistant à déclencher au moins une première alerte d'un passager du véhicule V qui est choisie parmi une alerte de risque encouru et une alerte de préconisation d'au moins une action à effectuer.

Une telle première alerte de passager est destinée à attirer l'attention du passager sur l'existence d'un problème au niveau de la batterie de servitude BS et devant faire l'objet le plus rapidement possible d'une réparation dans un service après-vente. Cette première alerte peut se faire par affichage d'un premier témoin de service dédié (par exemple le témoin de batterie de servitude), éventuellement dans une couleur rouge, et/ou d'un second témoin de service dédié (par exemple le témoin d'arrêt immédiat (ou « stop »)), éventuellement dans une couleur rouge, ou d'un message d'alarme textuel dédié sur un écran du véhicule V, comme par exemple celui du tableau de bord ou celui du combiné central, et/ou par diffusion d'un message d'alarme sonore (ou audio) dédié via au moins un haut-parleur présent dans le véhicule V. L'affichage d'une première alerte perdure alors de préférence jusqu'à la fin de la phase de roulage du véhicule V.

En cas de détermination du deuxième état e2, le processeur PR et la mémoire MD peuvent être aussi agencés pour effectuer les opérations consistant à déclencher une seconde alerte de service pour le passager.

Une telle seconde alerte est seulement destinée à attirer l'attention du passager sur un possible problème afin qu'il pense à aller dans un service après-vente pour un contrôle technique. Cette alerte peut se faire par affichage du témoin de service général (non dédié), éventuellement dans une couleur orange, ou d'un message d'avertissement textuel dédié sur un écran du véhicule V, comme par exemple celui du tableau de bord ou celui du combiné central, et/ou par diffusion d'un message d'avertissement sonore (ou audio) dédié via au moins un haut-parleur présent dans le véhicule V. L'affichage d'une seconde alerte perdure alors de préférence jusqu'à la fin de la phase de roulage du véhicule V.

On notera également que le processeur PR et la mémoire MD peuvent être aussi agencés pour effectuer les opérations consistant à déterminer l'état de la batterie de servitude BS en fonction en outre d'une information de fiabilité. On comprendra en effet qu'une telle information est de nature à renforcer l'intérêt qu'offre la connaissance de l'état en cours de la batterie de servitude BS, puisqu'il garantit que cet état est conforme à la réalité.

L'information de fiabilité peut, par exemple, être choisie parmi au moins :
- une première information if1 représentative d'une absence de fiabilité, car les résistances internes et tensions minimales sont considérées comme non fiables en raison de leurs valeurs anormales ou d'une variation anormale,
- une deuxième information if2 représentative d'une impossibilité de réaliser les déterminations des résistances internes rm (ou rmk) et tensions minimales (um (ou umk),
- une troisième information if3 représentative d'une incertitude quant à la possibilité de réaliser le test sécuritaire complètement, par exemple en raison de conditions non optimales pour le réussir ou d'une interruption du test sécuritaire requise par un calculateur du véhicule V (éventuellement CS), et
- une quatrième information if4 représentative d'une fiabilité certaine, car les résistances internes rm (ou rmk) et tensions minimales um (ou umk) sont considérées comme fiables en raison de leurs valeurs normales.

Par exemple, on peut considérer qu'une résistance interne rmk (ou rm) a une variation normale lorsque la valeur du courant sortant de la batterie de servitude BS est devenue inférieure à une valeur de courant prédéfinie (par exemple -50 A) fonction de ccc et que ce courant sortant a varié (i1 - i2) d'une valeur supérieure à la valeur de courant prédéfinie pendant la durée paramétrable (par exemple égal à 5 ms), ou lorsque la tension minimale umk (ou um) est strictement supérieure à une valeur de tension prédéfinie (par exemple 11 V) après une variation de tension supérieure à une valeur prédéfinie (par exemple 1 V). Dans tous les autres cas on considère que la résistance interne rmk (ou rm) a une variation anormale.

On notera également, comme illustré non limitativement sur la figure 2, que le calculateur CS (ou l'éventuel calculateur du dispositif de surveillance DS) peut aussi comprendre, en complément des mémoire vive MD et processeur PR, une mémoire de masse MM, notamment pour le stockage des tensions minimales um (ou umk) déterminées, des courants imk déterminés, des résistances internes rm (ou rmk) déterminées, et des éventuelles données numériques de la cartographie, et de données intermédiaires intervenant dans tous ses calculs et traitements. Par ailleurs, ce calculateur CD peut aussi comprendre une interface d'entrée IE pour la réception d'au moins les tensions minimales um (ou umk) déterminées, les courants imk déterminés, et les messages signalant la mise en fonctionnement du GMP électrique pour les utiliser dans des calculs ou traitements, éventuellement après les avoir mis en forme et/ou démodulés et/ou amplifiés, de façon connue en soi, au moyen d'un processeur de signal numérique PR'. De plus, ce calculateur CS (ou l'éventuel calculateur du dispositif de surveillance DS) peut aussi comprendre une interface de sortie IS, notamment pour délivrer les commandes d'alerte et ordres de déclenchement déterminés par le dispositif de surveillance DS.

L'invention peut aussi être considérée sous la forme d'un procédé de surveillance destiné à être mis en œuvre dans le véhicule V décrit ci-avant afin de permettre la surveillance de l'état de sa batterie de servitude BS.

Ce procédé de surveillance comprend une étape 10-70 dans laquelle, en cas de mise en fonctionnement du GMP électrique, on déclenche une consommation de courant choisie ccc par le réseau de bord RB via le générateur d'énergie électrique GE puis via la batterie de servitude BS, au moins une fois, afin de déterminer une tension minimale um aux bornes de la batterie de servitude BS et une résistance interne rm de cette dernière (BS), puis on détermine un état de la batterie de servitude BS en fonction de ces tension minimale um et résistance interne rm déterminées.

On a schématiquement illustré sur la figure 3 un exemple d'algorithme mettant en œuvre un procédé de surveillance 10-70 selon l'invention.

L'algorithme comprend une sous-étape 10 qui débute lorsque le dispositif de surveillance DS est informé de la mise en fonctionnement du GMP électrique et dans laquelle on débute une phase préparatoire initiale.

Puis, après l'expiration de la quatrième durée d4 (pendant laquelle le réseau de bord RB consomme du courant normalement (ccnd) via le générateur d'énergie électrique GE, on déclenche dans une sous-étape 20 une consommation de courant choisie ccc par le réseau de bord RB via le générateur d'énergie électrique GE pendant une troisième durée d3 (par exemple égale à d2).

Puis, après l'expiration de la troisième durée d3 (et donc à la fin de la phase préparatoire initiale), on débute une phase de diagnostic dans une sous-étape 30 en déclenchant une consommation de courant choisie ccc par le réseau de bord RB via la batterie de servitude BS pendant une première durée d1 choisie, afin de déterminer une tension minimale umk aux bornes de la batterie de servitude BS et une résistance interne rmk de cette dernière (BS). Puis, dans une sous-étape 40 on incrémente d'une unité la valeur vc d'un compteur de phases de diagnostic (initialement mise à zéro lors de la sous-étape 10).

Puis, dans une sous-étape 50 on détermine si la valeur vc du compteur de phases de diagnostic est égale à un second seuil s2 (par exemple égal à trois). Dans la négative (vc < s2), on retourne effectuer la sous-étape 20.

En revanche, dans l'affirmative (vc = s2), on détermine dans une sous-étape 60 une tension minimale moyenne um à partir des tensions minimales umk déterminées (à chaque itération) et une résistance interne moyenne rm à partir des résistances internes rmk déterminées (à chaque itération). Puis, dans une sous-étape 70 on détermine un état de la batterie de servitude BS en fonction des tension minimale moyenne um et résistance interne moyenne rm déterminées. On peut alors décider des mesures devant être prises compte tenu de l'état déterminé.

On notera également que l'invention propose aussi un produit programme d'ordinateur (ou programme informatique) comprenant un jeu d'instructions qui, lorsqu'il est exécuté par des moyens de traitement de type circuits électroniques (ou hardware), comme par exemple le processeur PR, est propre à mettre en œuvre le procédé de surveillance décrit ci-avant pour surveiller l'état de la batterie de servitude BS du véhicule V.

## Revendications

1. Dispositif de surveillance (DS) pour un véhicule (V) comprenant un groupe motopropulseur électrique et un réseau de bord (RB) alimenté en énergie électrique par un groupe d'alimentation comportant une batterie de servitude (BS) rechargeable et au moins un générateur d'énergie électrique (GE), **caractérisé en ce qu'**il comprend au moins un processeur (PR) et au moins une mémoire (MD) agencés pour effectuer les opérations consistant, en cas de mise en fonctionnement dudit groupe motopropulseur électrique, à déclencher une consommation de courant choisie par ledit réseau de bord (RB) via ledit générateur d'énergie électrique (GE) puis via ladite batterie de servitude (BS), au moins une fois, afin de déterminer une tension minimale aux bornes de ladite batterie de servitude (BS) et une résistance interne de cette dernière (BS), puis à déterminer un état de ladite batterie de servitude (BS) en fonction de ces tension minimale et résistance interne déterminées.

2. Dispositif selon la revendication 1, **caractérisé en ce que** ledit processeur (PR) et ladite mémoire (MD) sont agencés pour effectuer les opérations consistant à déclencher une consommation de courant choisie par ledit réseau de bord (RB) via ledit générateur d'énergie électrique (GE) puis via ladite batterie de servitude (BS), au moins deux fois de suite pendant une première durée choisie, afin de déterminer à chaque fois une tension minimale aux bornes de ladite batterie de servitude (BS) et une résistance interne de cette dernière (BS), puis à déterminer une tension minimale moyenne à partir desdites tensions minimales déterminées et une résistance interne moyenne à partir desdites résistances internes déterminées, puis ledit état de la batterie de servitude (BS) en fonction de ces tension minimale moyenne et résistance interne moyenne déterminées.

3. Dispositif selon la revendication 2, **caractérisé en ce que** ledit processeur (PR) et ladite mémoire (MD) sont agencés pour effectuer les opérations consistant à déclencher une consommation de courant par ledit réseau de bord (RB) via ledit générateur d'énergie électrique (GE) pendant une deuxième durée choisie, après chaque consommation de courant choisie par ledit réseau de bord (RB) via ladite batterie de servitude (BS) pendant ladite première durée choisie, hormis une dernière consommation de courant choisie par ledit réseau de bord (RB) via ladite batterie de servitude (BS).

4. Dispositif selon l'une des revendications 1 à 3, **caractérisé en ce que** ledit processeur (PR) et ladite mémoire (MD) sont agencés pour effectuer les opérations consistant à déclencher ladite consommation de courant choisie par ledit réseau de bord (RB) via ledit générateur d'énergie électrique (GE) pendant une troisième durée choisie faisant suite à une autre consommation de courant, non déclenchée, par ledit réseau de bord (RB) via ledit générateur d'énergie électrique (GE) pendant une quatrième durée choisie.

5. Dispositif selon l'une des revendications 1 à 4, **caractérisé en ce que** ledit processeur (PR) et ladite mémoire (MD) sont agencés pour effectuer les opérations consistant à déclencher chaque consommation de courant choisie par ledit réseau de bord (RB) via ladite batterie de servitude (BS) en déclenchant une réduction de tension choisie dudit générateur d'énergie électrique (GE) pendant un intervalle de temps compris entre 1 ms et 8 ms.

6. Dispositif selon l'une des revendications 1 à 5, **caractérisé en ce que** ledit processeur (PR) et ladite mémoire (MD) sont agencés pour effectuer les opérations consistant à déterminer chaque tension minimale et chaque résistance interne lorsqu'un courant sortant de ladite batterie de servitude (BS) croit d'une valeur supérieure à un premier seuil pendant une durée paramétrable débutant en même temps que débute une première durée choisie.

7. Dispositif selon l'une des revendications 1 à 6, **caractérisé en ce que** ledit processeur (PR) et ladite mémoire (MD) sont agencés pour effectuer les opérations consistant à déterminer ledit état dans un groupe comprenant un premier état représentatif d'une impossibilité à assurer une alimentation électrique dudit réseau de bord (RB) adaptée à des besoins d'alimentation électrique au moins partielle d'au moins un organe électrique sécuritaire, d'un deuxième état représentatif d'une incertitude de capacité à assurer une alimentation électrique dudit réseau de bord (RB) adaptée à des besoins d'alimentation électrique au moins partielle d'au moins un organe électrique sécuritaire, et d'un troisième état représentatif d'une capacité à assurer une alimentation électrique dudit réseau de bord (RB) adaptée à des besoins d'alimentation électrique au moins partielle d'au moins un organe électrique sécuritaire.

8. Véhicule (V) comprenant un groupe motopropulseur électrique et un réseau de bord (RB) alimenté en énergie électrique par un groupe d'alimentation comportant une batterie de servitude (BS) rechargeable et au moins un générateur d'énergie électrique (GE), **caractérisé en ce qu'**il comprend en outre un dispositif de surveillance (DS) selon l'une des revendications précédentes.

9. Procédé de surveillance pour un véhicule (V) comprenant un groupe motopropulseur électrique et un réseau de bord (RB) alimenté en énergie électrique par un groupe d'alimentation comportant une batterie de servitude (BS) rechargeable et au moins un générateur d'énergie électrique (GE), **caractérisé en ce qu'**il comprend une étape (10-70) dans laquelle, en cas de mise en fonctionnement dudit groupe motopropulseur électrique, on déclenche une consommation de courant choisie par ledit réseau de bord (RB) via ledit générateur d'énergie électrique (GE) puis via ladite batterie de servitude (BS), au moins une fois, afin de déterminer une tension minimale aux bornes de ladite batterie de servitude (BS) et une résistance interne de cette dernière (BS), puis on détermine un état de ladite batterie de servitude (BS) en fonction de ces tension minimale et résistance interne déterminées.

10. Produit programme d'ordinateur comprenant un jeu d'instructions qui, lorsqu'il est exécuté par des moyens de traitement, est propre à mettre en œuvre le procédé de surveillance selon la revendication 9 pour surveiller l'état d'une batterie de servitude (BS) rechargeable d'un véhicule (V) comprenant un groupe motopropulseur électrique et un réseau de bord (RB) alimenté en énergie électrique par un groupe d'alimentation comportant ladite batterie de servitude (BS) et au moins un générateur d'énergie électrique (GE).

## Patentansprüche

1. Überwachungsvorrichtung (DS) für ein Fahrzeug (V), das einen elektrischen Antriebsstrang und ein Bordnetz (RB) umfasst, das von einer Stromversorgungseinheit mit elektrischer Energie versorgt wird, die eine wiederaufladbare Servicebatterie (BS) und mindestens einen Generator für elektrische Energie (GE) umfasst, **dadurch gekennzeichnet, dass** sie mindestens einen Prozessor (PR) und mindestens einen Speicher (MD) umfasst, die dazu eingerichtet sind, die Operationen auszuführen, die darin bestehen, bei Inbetriebnahme des elektrischen Antriebsstrangs mindestens einmal eine vom Bordnetz (RB) gewählte Stromaufnahme über den Generator für elektrische Energie (GE) und dann über die Servicebatterie (BS) auszulösen, um eine Mindestspannung an den Anschlüssen der Servicebatterie (BS) und einen Innenwiderstand derselben zu bestimmen, und dann einen Zustand der Servicebatterie (BS) in Abhängigkeit von dieser bestimmten Mindestspannung und diesem bestimmten Innenwiderstand zu bestimmen.

2. Vorrichtung nach Anspruch 1, **dadurch gekennzeichnet, dass** der Prozessor (PR) und der Speicher (MD) dazu eingerichtet sind, die folgenden Vorgänge auszuführen: Auslösen einer gewählten Stromaufnahme durch das Bordnetz (RB) über den Generator für elektrische Energie (GE) und dann über die Servicebatterie (BS), und zwar mindestens zweimal hintereinander für eine erste gewählte Dauer, um jedes Mal eine Mindestspannung an den Anschlüssen der Servicebatterie (BS) und einen Innenwiderstand derselben zu bestimmen, dann Bestimmen einer durchschnittlichen Mindestspannung aus den bestimmten Mindestspannungen und eines durchschnittlichen Innenwiderstands aus den bestimmten Innenwiderständen, und dann Bestimmen des Zustands der Servicebatterie (BS) als Funktion dieser bestimmten durchschnittlichen Mindestspannung und des durchschnittlichen Innenwiderstands.

3. Vorrichtung nach Anspruch 2, **dadurch gekennzeichnet, dass** der Prozessor (PR) und der Speicher (MD) so angeordnet sind, dass sie nach jeder vom Bordnetz (RB) über die Servicebatterie (BS) gewählten Stromaufnahme während der ersten gewählten Dauer, mit Ausnahme der letzten vom Bordnetz (RB) über die Servicebatterie (BS) gewählten Stromaufnahme, eine Stromaufnahme des Bordnetzes (RB) über den Stromgenerator (GE) für eine zweite gewählte Dauer auslösen.

4. Vorrichtung nach einem der Ansprüche 1 bis 3, **dadurch gekennzeichnet, dass** der Prozessor (PR) und der Speicher (MD) so angeordnet sind, dass sie nach einer weiteren, nicht ausgelösten Stromaufnahme des Bordnetzes (RB) über den Stromgenerator (GE) für eine vierte gewählte Dauer eine Stromaufnahme des Bordnetzes (RB) über den Stromgenerator (GE) für eine dritte gewählte Dauer auslösen.

5. Vorrichtung nach einem der Ansprüche 1 bis 4, **dadurch gekennzeichnet, dass** der Prozessor (PR) und der Speicher (MD) dazu eingerichtet sind, die Operationen auszuführen, die darin bestehen, jeden vom Bordnetz (RB) über die Servicebatterie (BS) gewählten Stromverbrauch durch Auslösen einer gewählten Spannungsreduzierung des Stromgenerators (GE) für ein Zeitintervall zwischen 1 ms und 8 ms auszulösen.

6. Vorrichtung nach einem der Ansprüche 1 bis 5, **dadurch gekennzeichnet, dass** der Prozessor (PR) und der Speicher (MD) dazu eingerichtet sind, die Operationen auszuführen, die darin bestehen, jede Mindestspannung und jeden Innenwiderstand zu bestimmen, wenn ein die Servicebatterie (BS) verlassender Strom für eine konfigurierbare Dauer, die gleichzeitig mit dem Beginn einer ersten gewählten Dauer beginnt, um einen Wert größer als einen ersten Schwellenwert ansteigt.

7. Vorrichtung nach einem der Ansprüche 1 bis 6, **dadurch gekennzeichnet, dass** der Prozessor (PR) und der Speicher (MD) dazu eingerichtet sind, die Operationen durchzuführen, die in der Bestimmung des Zustands in einer Gruppe bestehen, die einen ersten Zustand repräsentiert, der die Unmöglichkeit der Sicherstellung einer zumindest teilweisen Stromversorgung des Bordnetzes (RB) darstellt, die mindestens einen Teil des Stromversorgungsbedarfs mindestens einer sicheren elektrischen Komponente deckt, einen zweiten Zustand repräsentiert, der die Unsicherheit der Fähigkeit zur Sicherstellung einer zumindest teilweisen Stromversorgung des Bordnetzes (RB) darstellt, die mindestens einen Teil des Stromversorgungsbedarfs mindestens einer sicheren elektrischen Komponente deckt, und einen dritten Zustand repräsentiert, der die Fähigkeit zur Sicherstellung einer zumindest teilweisen Stromversorgung des Bordnetzes (RB) darstellt, die mindestens einen Teil des Stromversorgungsbedarfs mindestens einer sicheren elektrischen Komponente deckt.

8. Fahrzeug (V) mit einem elektrischen Antriebsstrang und einem Bordnetz (RB), das von einer Stromversorgungseinheit mit einer wiederaufladbaren Servicebatterie (BS) und mindestens einem Stromgenerator (GE) mit elektrischer Energie versorgt wird, **dadurch gekennzeichnet, dass** es zusätzlich eine Überwachungsvorrichtung (DS) nach einem der vorhergehenden Ansprüche umfasst.

9. Überwachungsverfahren für ein Fahrzeug (V) mit einem elektrischen Antriebsstrang und einem Bordnetz (RB), das von einer Stromversorgungseinheit mit einer wiederaufladbaren Servicebatterie (BS) und mindestens einem Stromgenerator (GE) mit elektrischer Energie versorgt wird, **dadurch gekennzeichnet, dass** es einen Schritt (10-70) umfasst, in dem bei Inbetriebnahme des elektrischen Antriebsstrangs mindestens einmal eine vom Bordnetz (RB) gewählte Stromaufnahme über den Stromgenerator (GE) und anschließend über die Servicebatterie (BS) ausgelöst wird, um eine Mindestspannung an den Anschlüssen der Servicebatterie (BS) und einen Innenwiderstand der Servicebatterie (BS) zu bestimmen. Anschließend wird der Zustand der Servicebatterie (BS) in Abhängigkeit von dieser ermittelten Mindestspannung und diesem Innenwiderstand bestimmt.

10. Computerprogrammprodukt, das einen Satz von Anweisungen umfasst, der bei Ausführung durch Verarbeitungsmittel in der Lage ist, das Überwachungsverfahren nach Anspruch 9 zum Überwachen des Zustands einer wiederaufladbaren Servicebatterie (BS) eines Fahrzeugs (V) zu implementieren, das einen elektrischen Antriebsstrang und ein Bordnetz (RB) umfasst, das von einer Stromversorgungsgruppe mit elektrischer Energie versorgt wird, die die Servicebatterie (BS) und mindestens einen elektrischen Energiegenerator (GE) umfasst.

## Claims

1. Monitoring device (DS) for a vehicle (V) comprising an electric powertrain and an on-board network (RB) supplied with electrical energy by a power supply unit comprising a rechargeable service battery (BS) and at least one electrical energy generator (GE), **characterized in that** it comprises at least one processor (PR) and at least one memory (MD) arranged to carry out the operations consisting, in the event of said electric powertrain being put into operation, of triggering a current consumption chosen by said on-board network (RB) via said electrical energy generator (GE) then via said service battery (BS), at least once, in order to determine a minimum voltage at the terminals of said service battery (BS) and an internal resistance of the latter (BS), then to determine a state of said service battery (BS) as a function of these determined minimum voltage and internal resistance.

2. Device according to claim 1, **characterized in that** said processor (PR) and said memory (MD) are arranged to carry out the operations consisting of triggering a current consumption chosen by said on-board network (RB) via said electrical energy generator (GE) then via said service battery (BS), at least twice in succession for a first chosen duration, in order to determine each time a minimum voltage at the terminals of said service battery (BS) and an internal resistance of the latter (BS), then to determine an average minimum voltage from said determined minimum voltages and an average internal resistance from said determined internal resistances, then said state of the service battery (BS) as a function of these determined average minimum voltage and average internal resistance.

3. Device according to claim 2, **characterized in that** said processor (PR) and said memory (MD) are arranged to carry out the operations consisting of triggering a current consumption by said on-board network (RB) via said electrical energy generator (GE) for a second selected duration, after each current consumption chosen by said on-board network (RB) via said service battery (BS) during said first selected duration, except for a last current consumption chosen by said on-board network (RB) via said service battery (BS).

4. Device according to one of claims 1 to 3, **characterized in that** said processor (PR) and said memory (MD) are arranged to carry out the operations consisting of triggering said current consumption chosen by said on-board network (RB) via said electrical energy generator (GE) for a third selected duration following another current consumption, not triggered, by said on-board network (RB) via said electrical energy generator (GE) for a fourth selected duration.

5. Device according to one of claims 1 to 4, **characterized in that** said processor (PR) and said memory (MD) are arranged to carry out the operations consisting of triggering each current consumption chosen by said on-board network (RB) via said service battery (BS) by triggering a chosen voltage reduction of said electrical energy generator (GE) for a time interval of between 1 ms and 8 ms.

6. Device according to one of claims 1 to 5, **characterized in that** said processor (PR) and said memory (MD) are arranged to carry out the operations consisting of determining each minimum voltage and each internal resistance when a current leaving said service battery (BS) increases by a value greater than a first threshold for a configurable duration starting at the same time as the start of a first chosen duration.

7. Device according to one of claims 1 to 6, **characterized in that** said processor (PR) and said memory (MD) are arranged to carry out the operations consisting in determining said state in a group comprising a first state representative of an impossibility of ensuring an electrical supply of said on-board network (RB) adapted to at least partial electrical supply needs of at least one safe electrical component, a second state representative of an uncertainty of capacity to ensure an electrical supply of said on-board network (RB) adapted to at least partial electrical supply needs of at least one safe electrical component, and a third state representative of a capacity to ensure an electrical supply of said on-board network (RB) adapted to at least partial electrical supply needs of at least one safe electrical component.

8. Vehicle (V) comprising an electric powertrain and an on-board network (RB) supplied with electrical energy by a power supply unit comprising a rechargeable service battery (BS) and at least one electrical energy generator (GE), **characterized in that** it further comprises a monitoring device (DS) according to one of the preceding claims.

9. Monitoring method for a vehicle (V) comprising an electric powertrain and an on-board network (RB) supplied with electrical energy by a power supply unit comprising a rechargeable service battery (BS) and at least one electrical energy generator (GE), **characterized in that** it comprises a step (10-70) in which, in the event of said electric powertrain being put into operation, a current consumption chosen by said on-board network (RB) is triggered via said electrical energy generator (GE) then via said service battery (BS), at least once, in order to determine a minimum voltage at the terminals of said service battery (BS) and an internal resistance of the latter (BS), then a state of said service battery (BS) is determined as a function of these determined minimum voltage and internal resistance.

10. Computer program product comprising a set of instructions which, when executed by processing means, is capable of implementing the monitoring method according to claim 9 for monitoring the state of a rechargeable service battery (BS) of a vehicle (V) comprising an electric powertrain and an on-board network (RB) supplied with electrical energy by a power supply group comprising said service battery (BS) and at least one electrical energy generator (GE).
